# EUROPEAN PATENT APPLICATION

(11) **EP 3 157 025 A1**
(43) Date of publication of application: **19.04.2017**
(21) Application number: 15189995.2
(22) Date of filing: 15.10.2015
(51) Int. Cl.: H01G 9/20, C09B 47/00

(54) **PORPHYRIN-BASED SENSITIZER FOR DYE-SENSITIZED SOLAR CELL**

(71) Applicant: g2e glass2energy SA, 1690 Villaz-St-Pierre (CH)
(72) Inventor: YI, Chenyi, 1024 Ecublens (CH); ZAKEERUDDIN, Shaik Mohammed, 1030 Bussigny (CH); GRAETZEL, Michael, 1025 Saint-Sulpice (CH); GIORDANO, Fabrizio, 1025 Saint-Sulpice (CH)
(74) Representative: Schneiter, Sorin

(57) **Abstract**

The present invention relates to compounds based on porphyrin core, their use as sensitizer or dye and an electrochemical or optoelectronic device comprising a compound of the invention. Preferred compounds of the invention comprise a thioalkyl-substituted diaryl donor moiety. In a preferred embodiment, the compound has a clear green or green related color. The invention also relates to colored glass and construction elements comprising a solar cell sensitized with the sensitizer of the invention,

## Description

### Technical Field

The present invention relates to novel compounds comprising a porphyrin core, to the use of the compounds as sensitizers, to optoelectronic and/or electrochemical devices comprising the compounds, to a dye-sensitized solar cell, to a coloured glass comprising the device, and to construction elements, such as windows and facing elements comprising the device of the invention.

### Background Art and Problems Solved by the Invention

The worlds increasing demand for energy and global warming alarming us to reduce the use of fossil fuels and find alternate renewable energy sources. In field of solar energy conversion to electricity, the dye sensitized solar cells (DSCs) have attracted considerable attention in recent years due to its low cost and high efficiency. For example, DSCs based on ruthenium sensitizers have reached overall power conversion efficiency (PCE) of over 11% under standard Air Mass 1.5G illumination.

In recent years many efforts have been devoted to develop organic sensitizers for practical use due to their high molar absorption coefficients, ease of synthesis and structural modifications and to avoid the use of costly metal having limited availability.

Thus, PCE of donor-π-acceptor (D-π-A) organic sensitizers are attractive candidates to be used as sensitizers for DSC, since they reach more than 10% power conversion efficiency (Ito et al., Chem Commun., 2008, 5194).

Porphyrins have large absorption coefficients of their Soret and Q-bands in the visible region. They are also considered as being very attractive sensitizers. Further these phorphyrin sensitizers may be functionalized at the *meso* and *beta* positions of the chromophore to tune the spectral properties and energetics of porphyrins.

In the family of porphyrins, introducing donor and acceptor moieties and using zinc porphyrin chromophore as a π-bridge strategy has been produced a new family of efficient sensitizers by creating judicious directional electron flow from the donor to the acceptor moiety which anchors the dye to the surface of the oxide scaffold acting as electron acceptor (US2010/0125136, US2013/0090469). However, the power conversion efficiency of DSCs comprising such sensitizers are relatively low. It is an objective of the present invention to increase stability of devices comprising the dye and to increase performance.

When it comes to produce dye-sensitized solar cells for practical applications, additional constraints have to be considered, such as manufacturing costs. It is an objective of the present invention to provide a dye that can be produced at comparatively low costs and in high amounts. This starting materials that are readily available at comparatively low costs, few synthetic steps and comparatively high yields during each steps.

The present invention is further interested in the use of dye-sensitized solar cells as construction elements, for example in windows, glass-structures in buildings in general, and/or facings for buildings, for example. Glass and plastic are widely-used in construction, for example for increasing the use of natural and/or sunlight inside buildings and also for exploiting the sunlight's heating properties. When using construction elements comprising dye-sensitized solar cells, aesthetic factors, such as the color of the sensitizer also becomes relevant. Generally, certain brownish colors may be considered less decorative than bright and basic colors, such as green, blue, red, and yellow, for example. It is an objective of the present invention to provide sensitizing dyes having a green, green-like or green-related color, which when used in a dye-sensitized solar cell, provide devices with high stability and good power conversion efficiencies.

The present invention addresses the problems depicted above.

### Summary of the Invention

In an aspect the present invention provides a novel dye comprising a porphyrin core, an anchoring group and a diarylamine substituent, wherein said diaryl moiety comprises at least one thioalkyl substituent. Preferably, the anchoring group comprises an N-hydroxyacetamide anchoring group. Surprisingly, the dyes of the invention show comparatively high conversion efficiencies, high stability and can be manufactured at low costs. Interestingly, most of the dyes of the present invention have a pleasant, clear and bright green, greenish, green-related, greenish or green-like color.

In an aspect, the invention provides a compound of formula (I). 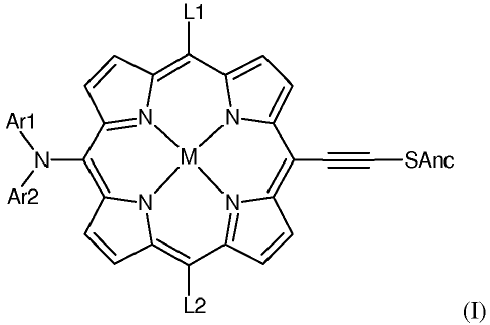 wherein
- M is either selected from a metal atom of the group Zn, Co, Cu, Fe, Mg, Mn, Ni, and Si, or represents two H (hydrogens) bound, respectively, to two nitrogen atoms of two of the four pyrrole subunits forming the porphyrin core in formula (I);
- SAnc is an anchoring substituent comprising an anchoring group, wherein said anchoring substituent is selected from the substituents of formulae (40)-(51) below 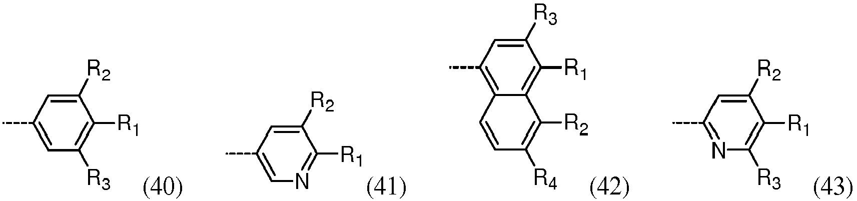 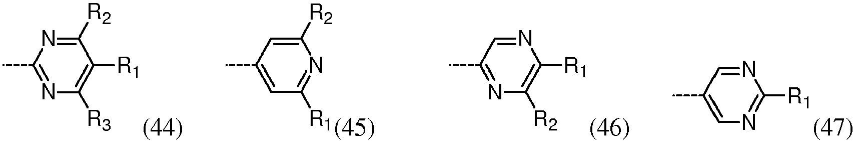 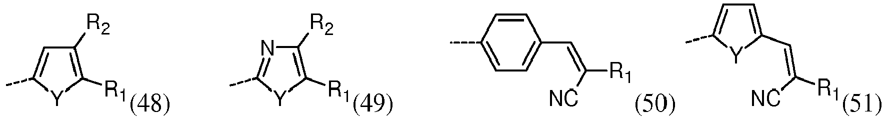
wherein, in said substituents of formulae (40)-(51), R₁, R₂, R₃ and R₄ are selected from H and from anchoring groups -CONHOH, -COOH, PO₃H₂, -PO₄H₂, -P(R₈)O₂H,-SO₃H₂, -SO₄H₂, 1,2-hydroxybenzene, 1-hydroxy-2-carboxybenzene, acetylacetonate, deprotonated forms of the aforementioned, organic and /or inorganic salts of said deprotonated forms, and chelating groups with π-conducting character, with the proviso that said substituent of (40)-(51) comprises at least one anchoring group, R₈ is selected from alkyl, alkenyl, alkynyl, aryl, alkylaryl, alkoxyaryl, and thioalkylaryl; Y is selected from O, N-R⁵, S, and Se; with R⁵ being selected from H and from substituted or unsubstituted C1-C16 alkyl, C2-C16 alkenyl, C2-C16 alkynyl, C6-C16 aryl, and C4-C16 heteroaryl, wherein heteroatoms are selected from O, S, or N;
- L1 and L2 are substituents independently selected from substituted and unsubstituted C6-C16 aryl, C4-C16 heteroaryl and from -NL₃L₄, wherein L₃ and L₄ are selected from substituted and unsubstituted C6-C16 aryl and C4-C16 heteroaryl, wherein heteroatoms of any one of said heteroaryl are selected from O, S, or N, and,
   wherein substituents of any one of said C6-C16 aryl and C4-C16 heteroaryl, if present, are selected from C1-C16 alkoxy, C1-C16 alkyl, C2-C16 alkenyl, C2-C16 alkynyl, halogen, -CH₂[OC₂H₄]ₚOCH₃, with p being 0 or an integer of 1 - 20, C1-C16 thioalkyl, C6-C14 aryl, C4-C14 heteroaryl, -NL₅L₆, wherein L₅ and L₆ are selected from substituted and unsubstituted C6-C14 aryl, and C4-C14 heteroaryl, and wherein said C1-C16 alkoxy, C1-C16 alkyl, C2-C16 alkenyl, C2-C16 alkynyl, C1-C16 thioalkyl, C6-C14 aryl, and C4-C14 heteroaryl, may be further substituted or may be unsubstituted,
   wherein further substituents, if present, are selected from C1-C10 alkyl, C2-C10 alkenyl, C2-C10 alkynyl, C1-C10 alkoxyl, -CH₂[OC₂H₄]_{q}OCH₃, with q being 0 or an integer of 1 - 5, C1-C10 thioalkyl, and halogen;
- Ar1 and Ar2 are selected from substituted C6-C16 aryl and C4-C16 heteroaryl, wherein heteroatoms are selected from O, S, or N and,
   wherein substituents of Ar1 and Ar2 are selected from unsubstituted or further substituted C1-C16 alkyl, C2-C16 alkenyl, C2-C16 alkynyl, C1-C16 alkoxyl, C2-C16 alkenoxyl, C2-C16 alkynoxyl, C1-C16 thioalkyl, C1-C16 thioalkenyl, C6-C14 aryl, C4-C16 heteroaryl, -NAr3, and -NAr4, wherein Ar3 and Ar4 are selected from unsubstituted or further substituted C6-C14 aryl and C4-C16 heteroaryl;
   wherein said further substituents, if present, are selected from C1-C10 alkyl, C2-C10 alkenyl, C2-C10 alkynyl, C1-C10 alkoxy, -CH₂[OC₂H₄]_{q}OCH₃, with q being 0 or an integer of 1 - 5, C1-C10 thioalkyl, and halogen;
   with the proviso that at least one substituent of Ar1 and Ar2, or at least one further substituent of a substituent of Ar1 and Ar2, is a thioalkyl substituent and/or a thioalkyl further substituent.

In an aspect, the invention provides the use of the compound of the invention as a dye, light harvester and/or a sensitizing compound.

In an aspect, the invention provides the use of the compound of the invention as a dye, light harvester and/or a sensitizing compound in an electrochemical and/or optoelectronic device.

In an aspect, the invention provides an electrochemical and/or optoelectronic device comprising the compound of formula (I) according to the invention.

In an aspect, the invention provides an electrochemical and/or optoelectronic device selected from a photo-electrochemical device, a light emitting device, an electrochromic or photo-electrochromic device, an electrochemical sensor, an electrochemical display or a dye sensitized solar cell, the device comprising the compound of the invention.

In an aspect, the invention provides a dye-sensitized solar cell.

In an aspect, the invention provides a colored glass comprising the device of the invention.

In an aspect, the invention provides a construction element comprising the device of the invention. The construction element may be selected from a window, a facing element for a building, and from the colored glass of the invention.

Further aspects and preferred embodiments are described in the detailed description of preferred embodiments and the appended claims.

### Brief Description of the Drawings

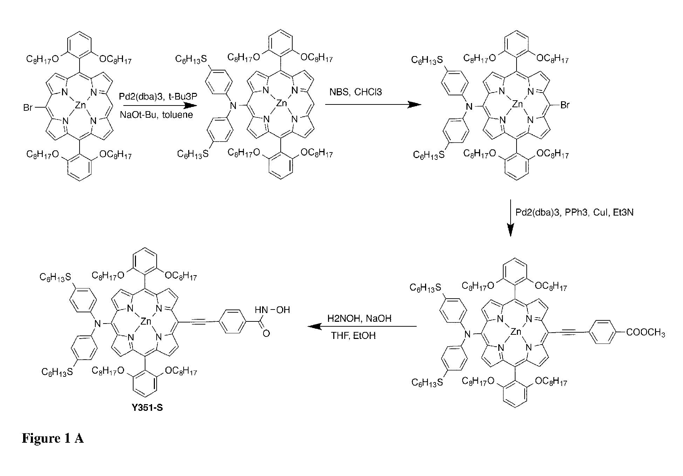

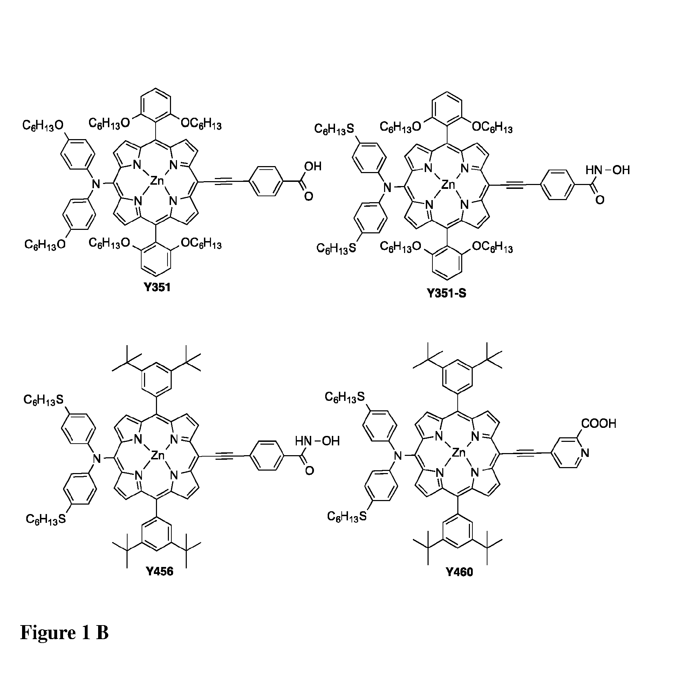

**Figure 1** **A** illustrates part of a synthetic approach for synthesizing compounds according to an embodiment of the invention.
**Figure 1** **B** shows compounds according to preferred embodiments of the invention.
**Figure 2** shows stability of dye-sensitized solar cells comprising a sensitizer Y351-S according to an embodiment of the present invention.
**Figure 3** shows stability of dye-sensitized solar cells comprising a sensitizer Y456 according to another embodiment of the present invention.

### Detailed Description of the Preferred Embodiments

For the purpose of the present specification, the expression "comprising", and its various grammatical forms, means "includes, amongst other". It is not intended to mean "consists only of".

For the purpose of the present specification, the number of carbons as indicated with respect to a particular substituent or moiety refers to the number of carbons of that substituent or moiety without the carbons of a possible substituent of the moiety or of a further substituent of a substituent, respectively. For example, in the compound of formula (I), if Ar1 and Ar2 are a substituted C6-C16 aryl, the carbons of the substituent of said C6-C16 aryl are not included in said C6-C16. If said substituent is a C1-C16 thioalkyl, said substituted Ar1 and Ar2 may comprise overall, including the carbons of the substituent, from 6+1 up to 16+16, that is, 7 to 32 carbons, for example.

In an embodiment, Ar1 and Ar2 of the compound of formula (I) are independently selected from a moiety according to any one of formulae (80) to (86) 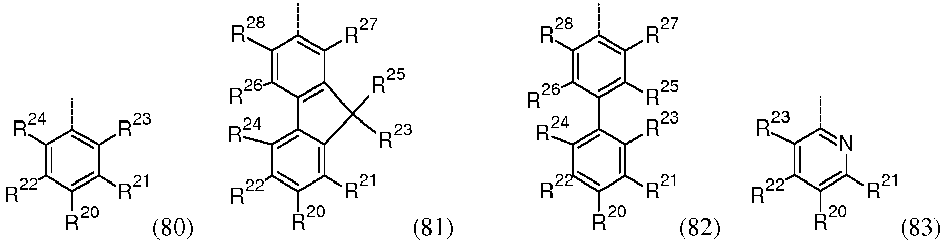 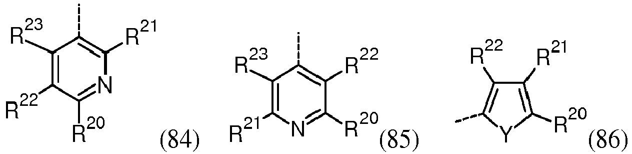 wherein R²⁰-R²⁸, in as far as present, are selected from H, C1-C16 thioalkyl, C1-C16 alkyl, C1-C16 alkoxyl, C1-C16 alkoxyalkyl, C6-C16 aryl, C4-C16 heteroaryl, C7-C16 arylalkyl, C7-C16 alkylaryl, C7-C16 alkoxyaryl, C5-C16 heteroarylalkyl, C5-C16 alkylheteroaryl; Y is selected from O, N-R⁵, S, and Se; with R⁵ being selected from H and from substituted or unsubstituted C1-C16 alkyl, C2-C16 alkenyl, C2-C16 alkynyl, C6-C16 aryl, and C4-C16 heteroaryl; wherein heteroatoms in any heteroaryl ring are selected independently from O, S, or N; with the proviso that the moiety of formula (80) to (86) comprises at least one C1-C16 thioalkyl substituent.

In a still more preferred embodiment, Ar1 and Ar2 are independently selected from a moiety according to any one of formulae (80'), (81') and (82') below 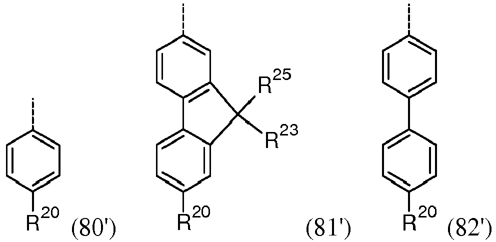 wherein R²⁰ is a C1-C16 thioalkyl, and, in moiety (81'), R²³ and R²⁵ are selected from C1-C16 alkyl, H, C1-C16 thioalkyl, and C1-C16 alkoxyl.

Regarding the anchoring substituent SAnc as defined herein, if in said substituents of formulae (40)-(51), there are more than one anchoring group, said anchoring groups are preferably identical. For example, in formula (40) of two or all three of R₁, R₂, and R₃ are anchoring groups, these two or three anchoring groups are preferably identical, for example all -CONHOH or all -COOH. This preferred embodiment also applies to the embodiment below concerning the substituents of formulae (90)-(97).

In a preferred embodiment, Ar1 and Ar2, and the substituents they carry, are identical. This preferably applies to all embodiments of the invention.

In an embodiment, SAnc is an anchoring substituent selected from the substituents of formulae (90)-(97) below 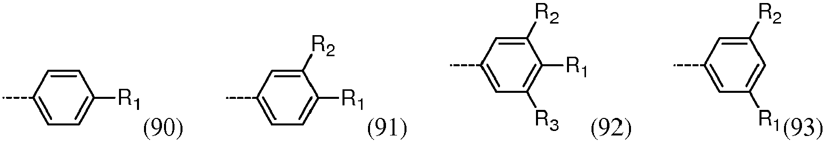 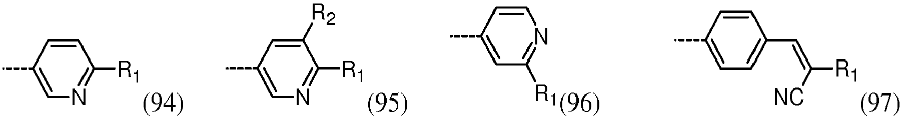 wherein R₁, R₂ and R₃, in as far as present, are an anchoring group selected from -CONHOH, -COOH, PO₃H₂, -PO₄H₂, -P(R₈)O₂H, -SO₃H₂, -SO₄H₂, deprotonated forms of the aforementioned, organic and/or inorganic salts of said deprotonated forms. R₈ is selected from alkyl, alkenyl, alkynyl, aryl, alkylaryl, alkoxyaryl, and thioalkylaryl.

In an embodiment, R₁, R₂, R₃ and R₄, in as far as present, are selected from the anchoring group -CONHOH⁻, deprotonated forms of the aforementioned, organic and /or inorganic salts of said deprotonated forms and from H, with the proviso that at least one of R₁ to R₄ is said anchoring group, and wherein said -CONHOH has the structure of formula (30)

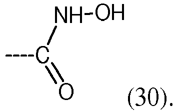

In an embodiment, L1 and L2 are the same or different and are selected from substituted and unsubstituted phenyl and thiophen-2-yl, wherein said substituents, if present, are selected from C1-C16 alkoxyl, C1-C16 thioalkyl, C1-C16 alkyl, C2-C16 alkenyl, C2-C16 alkynyl, C6-C16 aryl, C4-C16 heteroaryl, wherein said alkoxyl, thioalkyl, alkyl, alkenyl, alkynyl, aryl, and heteroaryl may be further substituted, said optional further substituents being selected from C1-C8 alkoyxyl, C1-C8 thioalkyl, C1-C8 alkyl, C2-C8 alkenyl, and C2-C8 alkynyl.

In an embodiment, L1 and L2 are the same or different and are selected from the substituents of formulae (70)-(84) below 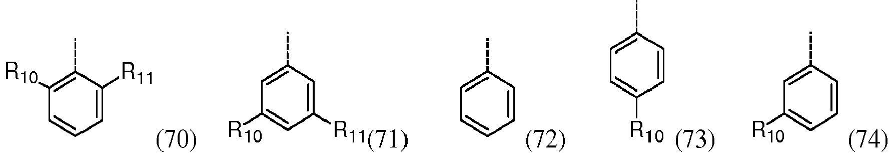 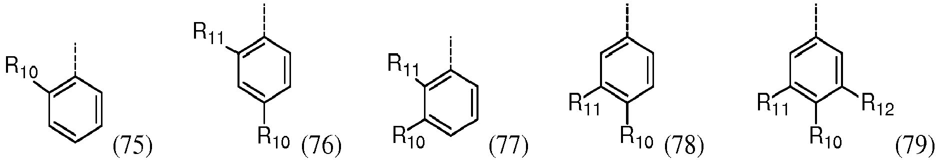 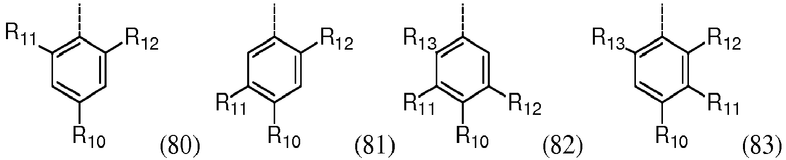 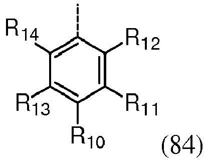 wherein R₁₀-R₁₄, in as far as present, are selected from halogen and from further substituted or unsubstituted C1-C16 alkoxy, C1-C16 alkyl, C1-C16 thioalkyl, C2-C16 alkenyl, C2-C16 alkynyl, -CH₂[OC₂H₄]ₚOCH₃, with p being 0 or an integer of 1 - 20, and halogen,
wherein further substituents may be selected from C1-C10 alkoxy, C1-C10 alkyl, C1-C10 thioalkyl C2-C10 alkenyl, C2-C10 alkynyl, -CH₂[OC₂H₄]_{q}OCH₃, with q being 0 or an integer of 1 - 5, and halogen.

In a preferred embodiment, L1 and L2 are identical.

In an embodiment, of the compound of formula (I) Ar1 and Ar2 are selected from moieties of formulae (80), (81) and (83) as defined above, SAnc is an anchoring substituent selected from the substituents of formulae (40), (41), (42), (43), (44), (45), (46), (57), (48), (49), (50) and (51) wherein R₁, R₂ and R₃, in as far as present, are selected from H and an anchoring group selected from -CONHOH and -COOH (including deprotonated forms and salts of the deprotonated forms), with the proviso that said substituent of (40)-(51) comprises at least one anchoring group, and L1 and L2 are selected from the substituents of formulae (70)-(84), wherein R₁₀-R₁₄, in as far as present, are selected from halogen and from further substituted or unsubstituted C1-C16 alkoxy and C1-C16 alkyl, with further substituents being as defined above.

In a preferred embodiment, of the compound of formula (I) Ar1 and Ar2 are selected from moieties of formulae (80) and (81) as defined above, wherein R²⁰-R²⁸, in as far as present, are selected from H, C1-C16 thioalkyl, C1-C16 alkyl, and C1-C16 alkoxyl, with the proviso that the moiety of formula (80) or (81) comprises at least one C1-C16 thioalkyl substituent; SAnc is an anchoring substituent selected from the substituents of formulae (40) and (41), wherein R₁, R₂ and R₃, in as far as present, are selected from H and an anchoring group selected from -CONHOH and -COOH (including deprotonated forms and salts of the deprotonated forms), with the proviso that said substituent of (40)-(41) comprises at least one anchoring group, and L1 and L2 are selected from the substituents of formulae (70), (71) and (72), wherein R₁₀ and R₁₁ are selected from C1-C16 alkoxy, C1-C16 alkyl and from halogen.

In a still more preferred embodiment, of the compound of formula (I) Ar1 and Ar2 are selected from moieties of formulae (80) and (81) as defined above, wherein R²⁰-R²⁸, in as far as present, are selected from H and C1-C16 thioalkyl, with the proviso that the moiety of formula (80) and (81), as applicable, comprises at least one C1-C16 thioalkyl substituent; SAnc is an anchoring substituent selected from the substituents of formulae (90) and (94), wherein R₁, is an anchoring group selected from -CONHOH and -COOH (including deprotonated forms and salts of the deprotonated forms), and L1 and L2 are selected from the substituents of formulae (70) and (71), wherein R₁₀ and R₁₁ are selected from C1-C16 alkoxy, C1-C16 alkyl and from halogen.

In a preferred embodiment, the compound of the invention is selected from the compounds of formulae (II) and (III) below: 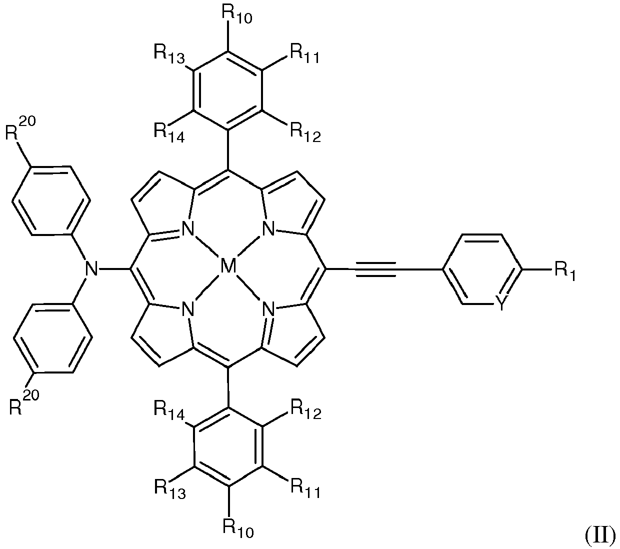 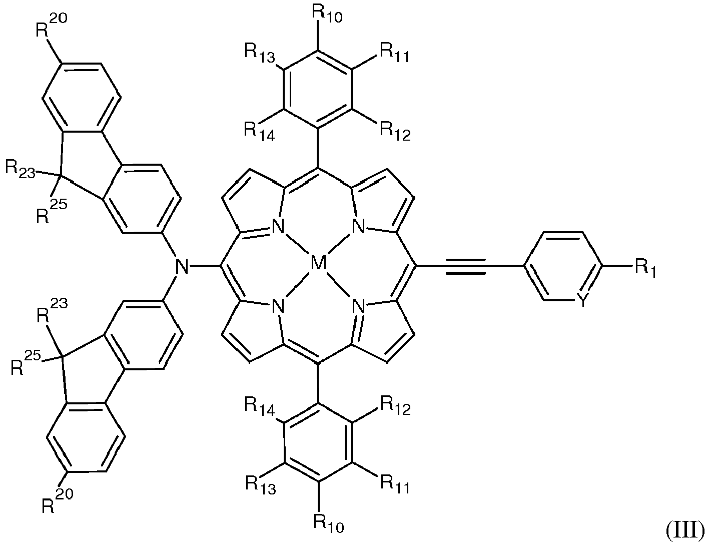 wherein, in said compounds of formulae (II) and (III),
- M is either selected from a metal atom of the group Zn, Co, Cu, Fe, Mg, Mn, Ni, and Si, or represents two H (hydrogens) bound, respectively, to two nitrogen atoms of two of the four pyrrole subunits forming the porphyrin core in formula (I);
- Y is selected from N or CH;
- R₁ is an anchoring group selected from -CONHOH, -COOH, PO₃H₂, -PO₄H₂, -P(R₈)O₂H,
- SO₃H₂, -SO₄H₂, deprotonated forms of the aforementioned, organic and /or inorganic salts of said deprotonated forms, wherein R₈ is selected from alkyl, alkenyl, alkynyl, aryl, alkylaryl, alkoxyaryl, and thioalkylaryl;
- R¹⁰ - R¹⁴ are independently selected from H, C1-C16 alkyl C1-C16 alkoxyl and C1-C16 thioalky;
- R²³ and R²⁵ are C1-C16 alkyl or H; and,
- R²⁰ is a C1-C16 thioalkyl.

In a preferred embodiment of the compounds of formula (II) and (III), R₁ is an anchoring group selected from -CONHOH and -COOH, preferably -CONHOH, deprotonated forms of the aforementioned, and organic and /or inorganic salts of said deprotonated forms;
- R¹⁰ - R¹⁴ are independently selected from H, C1-C10 alkyl, C1-C10 alkoxyl and C1-C10 thioalkyl;
- R²³ and R²⁵ are C1-C10 alkyl or H; and,
- R²⁰ is a C1-C10 thioalkyl.

In a preferred embodiment, M is a Zn metal atom (Zn²⁺). This applies to all embodiments of the present specification, in particular to the embodiments of the compounds of formulae (I), (II), (III) and (IV) and preferred embodiments of the compounds characterized by the structures of these formulae.

In a preferred embodiment, the compound of the invention is a compound selected from the compounds Y351-S, Y456, Y460 as shown in Figure 1 B.

In an aspect, the invention provides electrochemical and/or optoelectronic device comprising the compounds of the invention. Preferred examples of such devices are dye-sensitized solar cells. Dye-sensitized solar cells may have manifold construction schemes and may be flexible of not, and generally have an overall layered structure. Generally, the dye is adsorbed on a preferably nanoporous or nanostructured semiconductor layer, which may be made from TiO₂ nanoparticles or other materials, as is known from the art. The dye may form a monomolecular layer covering the surface of the semiconductor layer. The semiconductor comprising the dye absorbed on it via the dye's anchoring group forms the photoanode. On the front contact side, opposed to the dye-layer, the semiconductor layer is generally in electrical contact with a current collector, for example a support material (glass, plastic) coated with a conducting material. A passivating and/or insulating layer on the semiconductor layer may be present on the side where the dye is adsorbed, the latter having generally a thickness in the range of 0.2 to 1 nm. Upon irradiation, the dye injects electrons into the semiconductor layer. The dye withdraws electrons from an charge transfer layer, which may be an electrolyte, ionic liquid or p-type semiconducting hole transport material, for example. The charge transfer layer faces and is in contact with the dye on the other side of the dye layer, opposed to the semiconductor layer. The electrolyte or ionic liquid contains a redox couple, from which electrons are transferred to the dye. On the electric back contact side of the dye-sensitized solar cell, a cathode layer is provided, for example a metal layer, which is capable of transferring electrons to the electrolyte, ionic liquid or HTM. For example, WO2014180789 discloses solid-state solar cells containing a HTM. US 201170062541 discloses dye-sensitized solar cells in which the dye is a ruthenium complex. WO2012114316 and WO2012114315 disclose improved redox couples that can be used in electrolytes dye-sensitized solar cells. These references are cited purely for illustrative purposes for the fabrication of dye-sensitized solar cells.

### Examples

### 1. Synthesis of compound Y-351-S,5,15-bis(2,6-dihexoxyphenyl)-10-(bis(4-hexylthio-phenyl)amino)-20-(4-N-(hydroxy)benzamidato-phenylethynyl)porphyrinato] Zinc(II)

The synthesis of compound Y-351-S is illustrated in Figures 1 A and 1 B.

4,4'-dihexylthiodiphenylamine **1:** To a mixture of (2.1 g, 5 mmol) 4,4-diiodophenylamine and (2.0g 20 mmol) sodium tertbutyloxide, (95 mg, 0.5 mmol) copper iodide and (100 mg, 0.5 mmol) 1,10-phenanthroline in 20 mL toluene was added (1.2 g, 10 mmol) 1-hexanethiol; the mixture was refluxed under nitrogen for 24 h. After cooling to room temperature, the mixture was subjected to a short silica gel plug, washed with dichloromethane to get a white crystalline product. ¹H NMR (400 MHz, Acetone-*d*₆) d 7.23 (dd, *J* = 8.4, 1.9 Hz, 4H), 7.00 (dd, *J =* 8.4, 1.9 Hz, 4H), 2.78 (td, *J* = 7.4, 1.8 Hz, 4H), 1.60-1.15 (m, 16H), 0.84 (td, *J =* 6.8, 1.8 Hz, 6H).

Porphyrin **3:** (400 mg, 1 mmol) **1** was added to a mixture of (1.1g 1 mmol) **2** and (150 mg, 1.5 mmol) sodium tert-butyloxide using (5 mg 0.005 mmol) Pd₂(dba)₃ and 0.01 mmol t-Bu₃P as catalyst in 10 mL toluene. The mixture was heated at 110 °C under nitrogen for 12 h. After extraction with dichloromethane and water, the organic phase was evaporated under vacuum, the residue was purified by silica gel column chromatography to get (1.3 g, 0.9 mmol) **3.** ¹H NMR (400 MHz, Chloroform-*d*) d 10.08 (s, 1H), 9.29-9.25 (m, 2H), 9.23 (d, *J =* 4.6 Hz, 2H), 8.98 (dd, *J* = 4.4, 1.5 Hz, 2H), 8.86 (dd, *J* = 4.6, 1.6 Hz, 2H), 7.70 (t, *J* = 8.3 Hz, 2H), 7.21 (dd, *J =* 8.9, 3.3 Hz, 4H), 7.10-6.99 (m, 8H), 3.95-3.77 (m, 8H), 2.65 (d, *J =* 11.7 Hz, 4H), 1.40-0.37 (m, 82H).

Bromoporphyrin **4:** A solution of (720 mg, 0.5 mmol) **3** in 50 mL chloroform was shield from light with aluminum foil and cooled with ice water. And then a drop of pyridine was added to the above-mentioned solution before adding (90 mg, 0.5 mmol) NBS solution in THF. After 10 minutes, the solution was quenched with 2 mL of acetone and poured into 50 mL water. The mixture was extracted twice with 50 mL dichloromethane, the organic phase was combined and evaporated. The residue was subjected to a short silica gel plug, washed with silica gel to get the product. ¹H NMR (400 MHz, Chloroform-*d*) d 9.64 (d, *J* = 4.6 Hz, 2H), 9.14 (d, *J* = 4.6 Hz, 2H), 8.89 (d, *J* = 4.7 Hz, 2H), 8.77 (d, *J* = 4.6 Hz, 2H), 7.69 (t, *J* = 8.4 Hz, 2H), 7.18 (d, *J =* 8.3 Hz, 4H), 7.11-6.91 (m, 8H), 3.85 (t, *J =* 6.5 Hz, 8H), 2.64 (s, 4H), 1.42-0.31 (m, 82H).

Porphyrin **5:** A mixture of (150 mg, 0.1 mmol) **4,** (18 mg 0.11 mmol) 4-ethynyl-benzocarboxyl methyl ester, (5 mg 0.005 mmol) Pd₂(dba)₃, (10 mg, 0.04 mmol) PPh₃ and (2 mg, 0.02 mmol) CuI in 10 mL Et₃N was heated at 60 °C under nitrogen for 24 h. After cooling to room temperature, the mixture was poured into 0.5 M aq. HCl solution, and then extracted twice with dichloromethane. The organic phase was combined and evaporated. The residue was purified with silica gel column to get 140 mg solid product. ¹H NMR (400 MHz, Chloroform-*d*) d 9.73 (d, *J* = 4.6 Hz, 2H), 9.03 (d, *J* = 4.6 Hz, 2H), 8.95 (d, *J* = 4.5 Hz, 2H), 8.76 (d, *J* = 4.6 Hz, 2H), 8.24 (d, *J =* 8.2 Hz, 2H), 8.15-8.07 (m, 2H), 7.72 (t, *J =* 8.4 Hz, 2H), 7.03 (d, *J* = 8.5 Hz, 4H), 6.94 (d, *J =* 8.3 Hz, 4H), 6.49 (s, 4H), 4.01 (s, 3H), 3.96-3.78 (m, 8H), 2.15-1.81 (m, 4H), 1.28- 0.44 (m, 82H).

**Y351-S:** 70 mg (1 mmol) H₂NOH-HCl was dissolved in ethanol and added to (82 mg, 1.2 mmol) sodium ethoxide in ethanol, and then the precipitate was removed by filtration. The filtrate was added to a solution of (80 mg 0.05 mmol) **5** in 5 mL THF. The mixture was stirred at 45 °C for 12 h. After cooling to room temperature, the mixture was poured into 50 mL 0.5 M aq. HCl solution, and then extracted twice with 50 mL dichloromethane. The organic phase was dried with Na₂SO₄ and evaporated to get 75 mg product. ¹H NMR (400 MHz, Chloroform-*d*) d 9.71 (dd, *J =* 4.6, 1.7 Hz, 2H), 9.19-9.08 (m, 2H), 8.96 (dd, *J =* 4.6, 1.7 Hz, 2H), 8.75 (dt, *J* = 5.9, 3.0 Hz, 2H), 7.73 (dd, *J* = 9.3, 7.7 Hz, 2H), 7.38 (d, *J* = 7.6 Hz, 2H), 7.20 (d, *J =* 8.4 Hz, 3H), 7.06 -6.91 (m, 10H), 3.90 (p, *J =* 9.2, 8.2 Hz, 8H), 2.58 (s, 4H), 1.65-0.12 (m, 82H).

Compounds Y456 and Y460 were synthesized in an analogous manner.

### 2. Device fabrication

Electrodes with 8 µm transparent layer and 5 µm scattering layer of TiO₂ were screen-printed on fluorine-doped tin oxide (FTO). After sintering at 500 °C for 0.5 h and cooling to room temperature, the electrodes were treated with 33 mM TiCl₄ solution at 70 °C for 0.5 h. The films were sintered at 500 °C for 0.5 h and cooled to 80 °C before dipping into the dye solution (0.1 mM dye in 1:4 v/v Ethanol/THF) for 12 h. After the sensitization, the electrodes were rinsed with acetonitrile and dried in air. The cells were sealed with a Surlyn film and a platinized FTO counter electrode. The electrolyte (Z960) composition of this study was 1.0 M 1,3-dimethylimidazolium iodide, 0.05 M LiI, 0.03 M I₂, 0.1 M guanidiniumthiocyanate and 0.5 M 4-tert-butylpyridine in acetonitrile:valeronitrile (85:15, v/v). The composition of the Z988 electrolyte is as follows: 1,3-dimethylimidazolium iodide /1-ethyl-3-methylimidazolium iodide / 1-ethyl-3-methylimidazolium tetracyanoborate /I₂/ n-butyl-benzimidazole / guanidinium thiocyanate (molar ratio 12:12:16:1.67:3.33:0.67) and sulfolane (1:1 v/v).

### 3. Device performance

A 450 W xenon light source (Oriel, U.S.A.) was used to give an irradiance of 100 mW cm⁻² (the equivalent of one sun at air mass (AM) 1.5) at the surface of solar cells. The spectral output of the lamp was matched in the region of 350-750 nm with the aid of a Schott K113 Tempax sunlight filter (Präzisions Glas & Optik GmbH, Germany) so as to reduce the mismatch between the simulated and the true solar spectra. Various incident light intensities were regulated with wavelength neutral wire mesh attenuators. The current-voltage characteristics of the cell under these conditions were obtained by applying external potential bias to the cell and measuring the generated photocurrent with a Keithley model 2400 digital source meter (Keithley, U.S.A.). This process was fully automated using Wavemetrics software (http://www.wavemetrics.com/). A similar data acquisition system was used to control the incident photonto- collected electron conversion efficiency measurement. Under full computer control, light from a 300Wxenon lamp (ILC Technology, U.S.A.) was focused through a Gemini-180 double monochromator (Jobin Yvon Ltd., U.K.) onto the photovoltaic cell under test. The monochromator was incremented through the visible spectrum to generate the IPCE (*λ*) as defined by IPCE (*λ*)) 12400(*J*sc/*λϕ*), where *λ* is the wavelength, Jsc is short-circuit photocurrent density (mA cm⁻²), and *ϕ* is the incident radiative flux (mW cm⁻²). Photovoltaic performance was measured by using a metal mask with an aperture area of 0.158 cm².

### 4. Stability testing

Solar cells covered with a 50 *µ*m thick of polyester film (Preservation Equipment Ltd., U.K.) as a 400 nm UV cutoff filter were irradiated at open circuit under a Suntest CPS plus lamp (ATLAS GmbH, 100 mW cm⁻²) in ambient air at 60 °C. Photoelectrochemical measurements were carried out at room temperature after allowing the cells to cool down and equilibrate during 2 h.

### 5. Results

The photovoltaic performance of devices containing dyes encompassed by the invention is shown in Table 1 below.

**Table 1: photovoltaic characteristics of devices comprising the porphyrin dyes of the invention**

| Dye | Electrolyte | J_{sc} (mA cm⁻²) | V_{oc} (mV) | FF(%) | PCE (%) |
|---|---|---|---|---|---|
| Y351 | Z960 | 12.6 | 747 | 63.9 | 6.02 |
| Y351-S | Z960 | 17.8 | 717 | 72.1 | 9.13 |
| Y351-S | Z988 | 14.35 | 753 | 66.1 | 7.31 |
| Y456 | Z988 | 13.49 | 705 | 73.6 | 7.13 |
| Y460 | Z1328 | 5.66 | 602 | 71.1 | 2.43 |

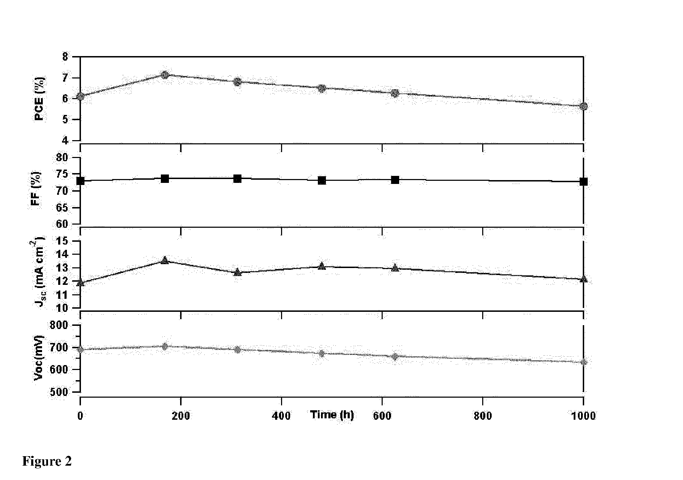

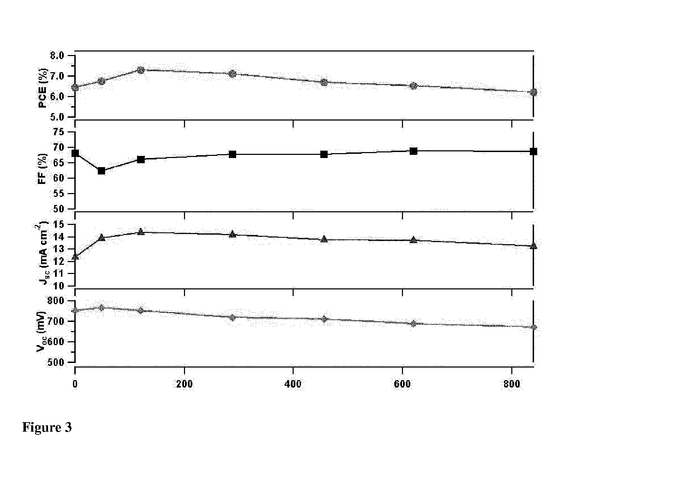

Compounds Y351-S, Y456 and Y460 comprise a thioalkyl substituent and/or a thioalkyl further substituent in accordance with the invention. Compared to dye Y351, which lacks such a substituent, the compounds of the invention exhibit increased power conversion efficiency (PCE).
The results of the stability tests conducted for 1000 hours with solar cells containing Y351-S and Y456 in conjunction with Z988 electrolyte are shown in Figures 2 and 3. As the figures show, the solar cells containing the compounds of the invention exhibit excellent stability.

While certain of the preferred embodiments of the present invention have been described and specifically exemplified above, it is not intended that the invention be limited to such embodiments. Various modifications may be made thereto without departing from the scope and spirit of the present invention, as set forth in the following claims.

## Claims

1. A compound of formula (I) 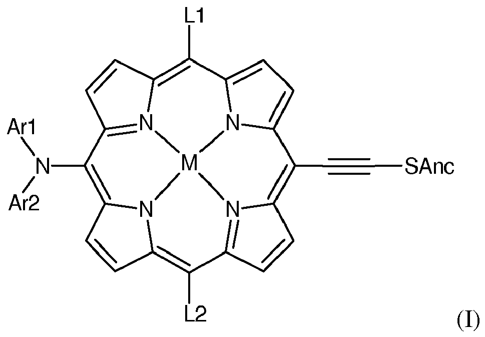 wherein
- M is either selected from a metal atom of the group Zn, Co, Cu, Fe, Mg, Mn, Ni, and Si, or represents two H (hydrogens) bound, respectively, to two nitrogen atoms of two of the four pyrrole subunits forming the porphyrin core in formula (I);
- SAnc is an anchoring substituent comprising an anchoring group, wherein said anchoring substituent is selected from the substituents of formulae (40)-(51) below 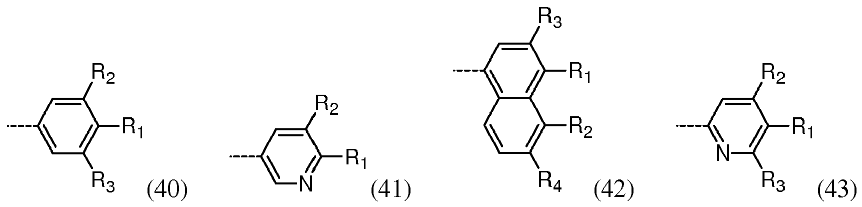 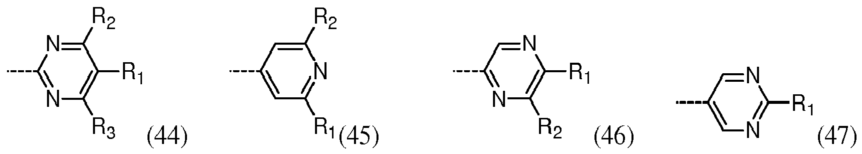 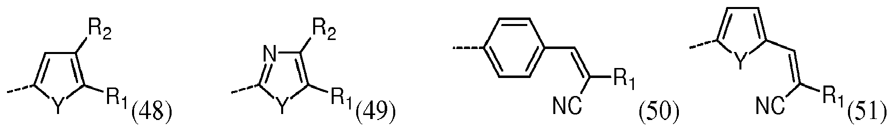 wherein, in said substituents of formulae (40)-(51), R₁, R₂, R₃ and R₄ are selected from H and from anchoring groups -CONHOH, -COOH, PO₃H₂, -PO₄H₂, -P(R₈)O₂H,-SO₃H₂, -SO₄H₂, 1,2-hydroxybenzene, 1-hydroxy-2-carboxybenzene, acetylacetonate, deprotonated forms of the aforementioned, organic and /or inorganic salts of said deprotonated forms, and chelating groups with π-conducting character, with the proviso that said substituent of (40)-(51) comprises at least one anchoring group; R₈ is selected from alkyl, alkenyl, alkynyl, aryl, alkylaryl, alkoxyaryl, and thioalkylaryl; Y is selected from O, N-R⁵, S, and Se; with R⁵ being selected from H and from substituted or unsubstituted C1-C16 alkyl, C2-C16 alkenyl, C2-C16 alkynyl, C6-C16 aryl, and C4-C16 heteroaryl, wherein heteroatoms are selected from O, S, or N;
- L1 and L2 are substituents independently selected from substituted and unsubstituted C6-C16 aryl, C4-C16 heteroaryl and from -NL₃L₄, wherein L₃ and L₄ are selected from substituted and unsubstituted C6-C16 aryl and C4-C16 heteroaryl, wherein heteroatoms of any one of said heteroaryl are selected from O, S, or N, and,
wherein substituents of any one of said C6-C16 aryl and C4-C16 heteroaryl, if present, are selected from C1-C16 alkoxy, C1-C16 alkyl, C2-C16 alkenyl, C2-C16 alkynyl, halogen, -CH₂[OC₂H₄]ₚOCH₃, with p being 0 or an integer of 1 - 20, C1-C16 thioalkyl, C6-C14 aryl, C4-C14 heteroaryl, -NL₅L₆, wherein L₅ and L₆ are selected from substituted and unsubstituted C6-C14 aryl, and C4-C14 heteroaryl, and wherein said C1-C16 alkoxy, C1-C16 alkyl, C2-C16 alkenyl, C2-C16 alkynyl, C1-C16 thioalkyl, C6-C14 aryl, and C4-C14 heteroaryl, may be further substituted or may be unsubstituted,
wherein further substituents, if present, are selected from C1-C10 alkyl, C2-C10 alkenyl, C2-C10 alkynyl, C1-C10 alkoxyl, -CH₂[OC₂H₄]_{q}OCH₃, with q being 0 or an integer of 1 - 5, C1-C10 thioalkyl, and halogen;
- Ar1 and Ar2 are selected from substituted C6-C16 aryl and C4-C16 heteroaryl, wherein heteroatoms are selected from O, S, or N and,
wherein substituents of Ar1 and Ar2 are selected from unsubstituted or further substituted C1-C16 alkyl, C2-C16 alkenyl, C2-C16 alkynyl, C1-C16 alkoxyl, C2-C16 alkenoxyl, C2-C16 alkynoxyl, C1-C16 thioalkyl, C1-C16 thioalkenyl, C6-C14 aryl, C4-C16 heteroaryl, -NAr3Ar4, wherein Ar3 and Ar4 are selected from unsubstituted or further substituted C6-C14 aryl and C4-C16 heteroaryl;
wherein said further substituents, if present, are selected from C1-C10 alkyl, C2-C10 alkenyl, C2-C10 alkynyl, C1-C10 alkoxy, -CH₂[OC₂H₄]_{q}OCH₃, with q being 0 or an integer of 1 - 5, C1-C10 thioalkyl, and halogen;
with the proviso that at least one substituent of Ar1 and Ar2, or at least one further substituent of a substituent of Ar1 and Ar2, is a thioalkyl substituent and/or a thioalkyl further substituent.

2. The compound of formula (I) according to any one of the preceding claims, wherein Ar1 and Ar2 are independently selected from a moiety according to any one of formulae (80) to (86) 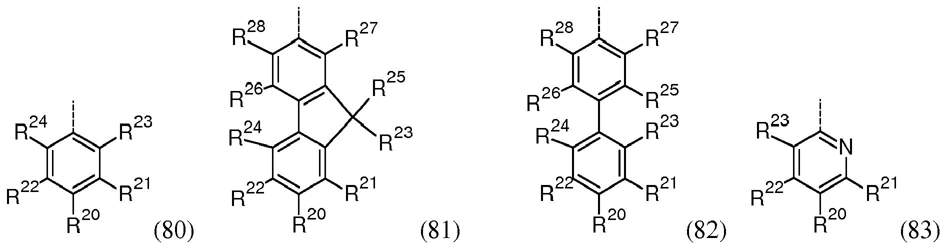 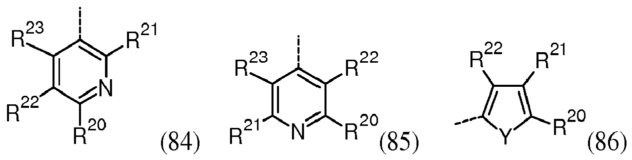 Wherein
R²⁰-R²⁸, in as far as present, are selected from H, C1-C16 thioalkyl, C1-C16 alkyl, C1-C16 alkoxyl, C1-C16 alkoxyalkyl, C6-C16 aryl, C4-C16 heteroaryl, C7-C16 arylalkyl, C7-C16 alkylaryl, C7-C16 alkoxyaryl, C5-C16 heteroarylalkyl, C5-C16 alkylheteroaryl;
Y is selected from O, N-R⁵, S, and Se; with R⁵ being selected from H and from substituted or unsubstituted C1-C16 alkyl, C2-C16 alkenyl, C2-C16 alkynyl, C6-C16 aryl, and C4-C16 heteroaryl;
wherein heteroatoms in any heteroaryl ring are selected independently from O, S, or N;
with the proviso that the moiety of formula (80) to (86) comprises at least one C1-C16 thioalkyl substituent.

3. The compound of formula (I) according to claim 1 or 2, wherein Ar1 and Ar2 are independently selected from a moiety according to any one of formulae (80'), (81') and (82') below 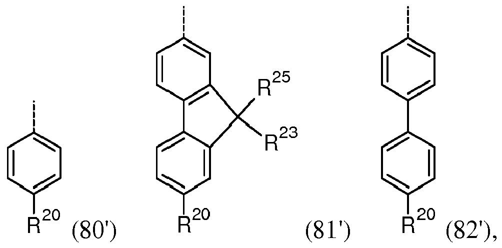 wherein R²⁰ is a C1-C16 thioalkyl, and, in moiety (81'), R²³ and R²⁵ are selected from C1-C16 alkyl, H, C1-C16 thioalkyl, and C1-C16 alkoxyl.

4. The compound of formula (I) according to any one of the preceding claims, wherein SAnc is an anchoring substituent selected from the substituents of formulae (90)-(97) below 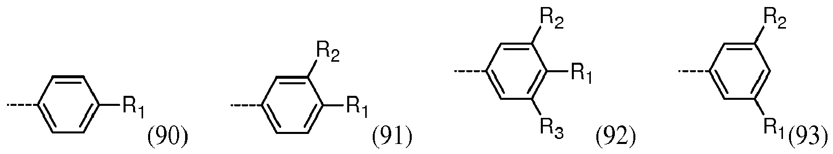 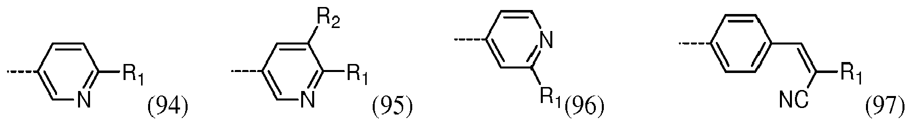 wherein R₁, R₂ and R₃, in as far as present, are an anchoring group selected from -CONHOH, -COOH, PO₃H₂, -PO₄H₂, -P(R₈)O₂H, -SO₃H₂, -SO₄H₂, deprotonated forms of the aforementioned, organic and/or inorganic salts of said deprotonated forms, and R₈ is selected from alkyl, alkenyl, alkynyl, aryl, alkylaryl, alkoxyaryl, and thioalkylaryl.

5. The compound of formula (I) according to any one of the preceding claims, wherein R₁, R₂, R₃ and R₄, in as far as present, are selected from the anchoring group -CONHOH, deprotonated forms of the aforementioned, organic and /or inorganic salts of said deprotonated forms and from H, with the proviso that at least one of R₁ to R₄ is said anchoring group, and wherein said -CONHOH is an anchoring group of formula (30)

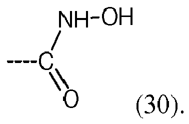

6. The compound of formula (I) according to any one of the preceding claims, wherein L1 and L2 are the same or different and are selected from substituted and unsubstituted phenyl and thiophen-2-yl, wherein said substituents, if present, are selected from C1-C16 alkoxyl, C1-C16 thioalkyl, C1-C16 alkyl, C2-C16 alkenyl, C2-C16 alkynyl, C6-C16 aryl, C4-C16 heteroaryl, wherein said alkoxyl, thioalkyl, alkyl, alkenyl, alkynyl, aryl, and heteroaryl may be further substituted, said optional further substituents being selected from C1-C8 alkoxyl, C1-C8 thioalkyl, C1-C8 alkyl, C2-C8 alkenyl, and C2-C8 alkynyl.

7. The compound of formula (I) according to any one of the preceding claims, wherein L1 and L2 are the same or different and are selected from the substituents of formulae (70)-(84) below 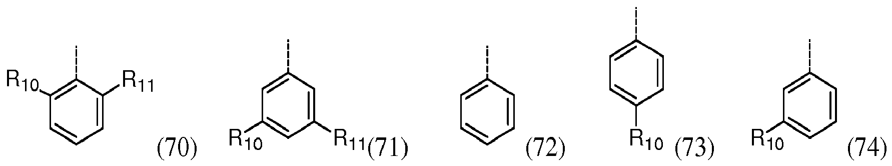 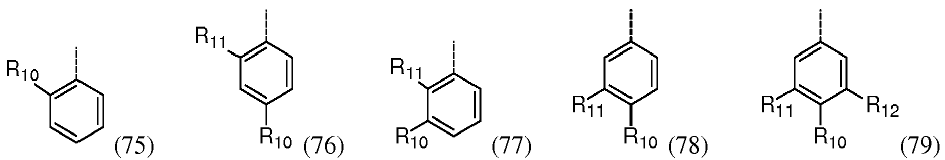 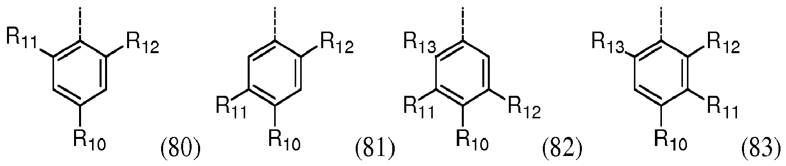 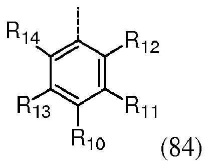 wherein R₁₀-R₁₄, in as far as present, are selected from halogen and from further substituted or unsubstituted C1-C16 alkoxy, C1-C16 alkyl, C1-C16 thioalkyl, C2-C16 alkenyl, C2-C16 alkynyl, -CH₂[OC₂H₄]ₚOCH₃, with p being 0 or an integer of 1 - 20, and halogen,
wherein further substituents may be selected from C1-C10 alkoxy, C1-C10 alkyl, C1-C10 thioalkyl C2-C10 alkenyl, C2-C10 alkynyl, -CH₂[OC₂H₄]_{q}OCH₃, with q being 0 or an integer of 1 - 5, and halogen.

8. The compound of any one of the preceding claims, which is selected from the compounds of formulae (II) and (III) below: 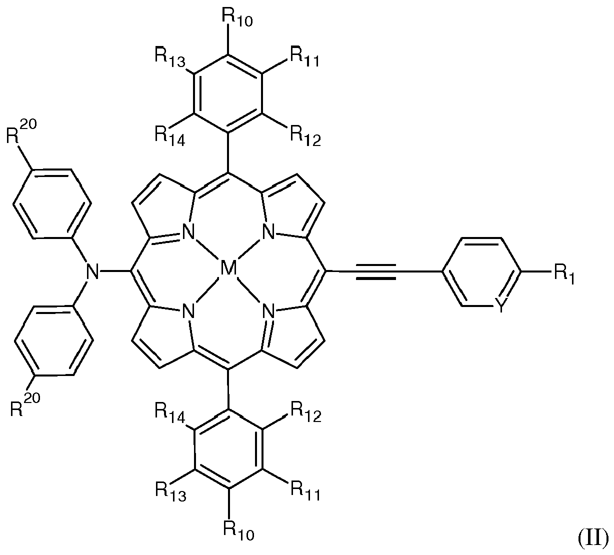 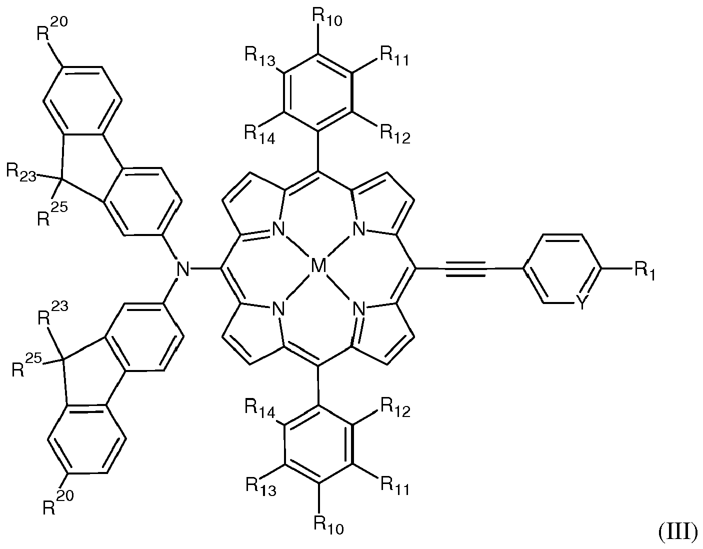 wherein
- M is either selected from a metal atom of the group Zn, Co, Cu, Fe, Mg, Mn, Ni, and Si, or represents two H (hydrogen) bound, respectively, to two nitrogen atoms of two of the four pyrrole subunits forming the porphyrin core in formula (I);
- Y is selected from N or CH;
- R₁ is an anchoring group selected from -CONHOH, -COOH, PO₃H₂, -PO₄H₂, -P(R₈)O₂H,
- SO₃H₂, -SO₄H₂, deprotonated forms of the aforementioned, organic and /or inorganic salts of said deprotonated forms, wherein R₈ is selected from alkyl, alkenyl, alkynyl, aryl, alkylaryl, alkoxyaryl, and thioalkylaryl;
- R¹⁰ - R¹⁴ are independently selected from H, C1-C16 alkyl C1-C16 alkoxyl and C1-C16 thioalkyl;
- R²³ and R²⁵ are C1-C16 alkyl or H; and,
- R²⁰ is a C1-C16 thioalkyl.

9. The compound of any one of the preceding claims, which is selected from the compounds Y351-S, Y456, Y460 shown in Figure 2 B.

10. Use of a compound of formula (I) according to any one of claims 1 to 9 as a dye, light harvester and/or a sensitizing compound in an electrochemical and/or optoelectronic device.

11. An electrochemical and/or optoelectronic device comprising a sensitizer, a dye, and/or a light harvester, said dye, sensitizer or light harvester being the compound according to any one of claims 1 to 9.

12. The device according to claim 11, wherein said device is selected from a photo-electrochemical device, a light emitting device, an electrochromic or photo-electrochromic device, an electrochemical sensor, an electrochemical display or a dye sensitized solar cell.

13. The device according to claim 11 and 12, which is a dye-sensitized solar cell.

14. A colored glass comprising the dye of any one of claims 1 to 9 and/or the device of any one of claims 11-13.

15. A construction element, such as a window or a facing element for a building, comprising the device of any one of claims 11-13 or the colored glass of claim 14.
